# EUROPÄISCHE PATENTSCHRIFT

(11) **EP 4 373 663 B1**
(45) Veröffentlichungstag und Bekanntmachung des Hinweises auf die Patenterteilung: **13.08.2025**
(21) Anmeldenummer: 22809099.9
(22) Anmeldetag: 25.10.2022
(51) Int. Cl.: B30B 15/06, B30B 3/00, B44B 5/02, C23C 14/06, C23C 14/04, C23C 14/35, C23C 14/56, B44C 3/02

(54) **PRESSWERKZEUG UND VERFAHREN ZUM HERSTELLEN EINES PRESSBLECHS**
PRESS TOOL AND METHOD FOR PRODUCING A PRESS PLATE
OUTIL DE PRESSE ET PROCÉDÉ DE FABRICATION D'UNE PLAQUE MACHINE

(30) Priorität: 04.11.2021 DE 102021128738; 30.09.2022 DE 102022125374
(43) Veröffentlichungstag der Anmeldung: 29.05.2024
(73) Patentinhaber: HUECK Rheinische GmbH, 41747 Viersen (DE)
(72) Erfinder: KAOUK, Ali, 41751 Viersen (DE); HAGEDORN, Thorsten, 47807 Krefeld (DE); THÖLEN, Berthold, 41748 Viersen (DE)
(74) Vertreter: Burger, Hannes Alfred
(86) Internationale Anmeldenummer: PCT/EP2022/079757
(87) Internationale Veröffentlichungsnummer: WO 2023/078731

(56) Entgegenhaltungen:
- EP-A1- 1 063 085
- EP-A1- 2 497 650
- EP-A2- 1 184 480
- CH-A5- 681 083
- DE-A1- 102019 127 659
- JP-A- H11 314 237
- US-A1- 2017 226 630

## Beschreibung

Die Erfindung betrifft ein Presswerkzeug mit einer Pressoberfläche und ein Verfahren zum Herstellen des Presswerkzeugs.

Presswerkzeuge z.B. in Form von Pressblechen, Endlosbändern oder Prägewalzen werden insbesondere in der holzverarbeitenden Industrie eingesetzt, um z.B. Möbel, Werkstoffplatten wie Laminate oder Paneele, also allgemein Werkstücke herzustellen. Die Werkstücke werden mit der Pressoberfläche des Presswerkzeugs verpresst, sodass die Werkstücke Oberflächen entsprechend der Pressoberfläche erhalten.

Werkstoffplatten, beispielsweise Holzwerkstoffplatten, werden für die Möbelindustrie und für den Innenausbau, beispielsweise für Laminatfußböden benötigt. Die Werkstoffplatten weisen einen Kern aus MDF (mitteldichte Faserplatte) oder HDF (hochdichte Faserplatte) auf, auf welchen Kern zumindest einseitig verschiedene Materialauflagen aufgelegt werden, beispielsweise eine (optische) Dekorschicht und eine Schutzschicht (Overlay-Schicht).

Um bei den hergestellten Werkstoffplatten einen Verzug zu vermeiden, werden solche Werkstoffplatten in der Regel beidseitig mit derselben Anzahl von Materialauflagen versehen; um die die einzelnen Lagen der Werkstoffplatten (Kern, Materialauflagen, etc.) miteinander zu verbinden, werden diese in einer Presse unter Verwendung spezieller Presswerkzeuge, insbesondere Pressbleche oder Endlosbänder, miteinander verpresst. Dabei erfolgt auch eine Oberflächenprägung der Werkstoffplatten. Üblicherweise kommen dabei Heißpressen zum Einsatz, um die verschiedenen Materialauflagen aus Duroplastharzen, beispielsweise Melaminharz, unter Wärmeeinwirkung durch eine Verschmelzung der Kunststoffmaterialien mit der Oberfläche des Kerns zu verbinden.

Die Dekorschichten bestimmen dabei das Muster und die Farbgestaltung der Werkstoffplatte; eine gewünschte Oberflächenstruktur hingegen kann durch Verwendung passender Presswerkzeuge erreicht werden. Beispielsweise kann ein Holz- oder Fliesendekor auf der Dekorschicht (Dekorpapier) aufgedruckt sein, oder es werden Dekorschichten mit Mustern und Farbgestaltungen verwendet, die entsprechend dem jeweiligen Verwendungszweck künstlerisch gestaltet sind. Hierbei können auch Overlay-Schichten verwendet werden, die auf der Ober- oder Unterseite bedruckt sind.

Zur Verbesserung einer naturgetreuen Nachbildung, insbesondere bei Werkstoffplatten mit Holz-, Fliesen- oder Natursteindekor, werden die Presswerkzeuge mit einer Oberflächenstrukturierung versehen, die deckungskonform zu der Dekorschicht ausgebildet ist und eine Negativabbildung der gewünschten Oberflächenstruktur ausbildet. Deshalb weisen die Presswerkzeuge ein 3D-Profil (Tiefenstrukturierung) auf, welches beispielsweise den Holznerven einer Holzoberfläche nachempfunden ist, um der Dekorschicht der Werkstoffplatte das Erscheinungsbild einer solchen Holzoberfläche zu verleihen.

Zur Erzielung der deckungskonformen Prägung der Werkstoffplatten bzw. der Laminate - also der erforderlichen Passgenauigkeit von Dekorschicht(en) und der Struktur der Pressoberfläche des Laminats - wird für die Produktion der Presswerkzeuge ein hoher Qualitätsstandard gefordert. Insbesondere werden die Pressbleche oder Endlosbänder hierbei als Ober- und Unterwerkzeug in Kurztaktpressen, welche mit Pressblechen und bevorzugt Presspolster belegt sind, oder in Doppelbandpressen bei Endlosbändern eingesetzt, wobei gleichzeitig die Prägung und die Erwärmung der Werkstoffplatten erfolgt, sodass die Duroplastharze der Dekor- und/oder Overlay-Schichten der Werkstoffplatten zunächst aufgeschmolzen werden, die der Struktur der Pressoberfläche der Presswerkzeuge entsprechende Oberflächenstruktur in die außenliegenden Materialauflagen eingebracht wird, und die strukturierten Materialauflagen durch anschließendes Aushärten mit dem Kern der Werkstoffplatte verbunden werden.

Die WO 2009/062488 A2 offenbart ein Verfahren zur Bearbeitung einer strukturierten Pressoberfläche eines Prägewerkzeugs. Die Oberfläche mit einer ersten Chromschicht vollflächig versehen, auf der in vorbestimmten Bereichen zumindest eine weitere Chromschicht angeordnet wird. Die Glanzgrade der beiden Chromschichten unterscheidet sich. Mittels der Pressoberfläche kann ein als Werkstoffplatte ausgebildetes Werkstück mit einer strukturierten Oberfläche hergestellt werden, die unterschiedliche Glanzgrade aufweist. Aufgrund der Verwendung der Chromschichten und mehrfacher Maskierungs- und Reinigungsschritte ist die Herstellung dieses Presswerkzeugs relativ umweltschädlich.

Die US 6,190,514 B1 offenbart ein Verfahren zum Herstellen einer ebenen Pressoberfläche, um aus mit Harz imprägniertem Papier ein dekoratives Laminat herzustellen. Dazu wird ein gewünschtes Finish auf einer ebenen Pressoberfläche erzeugt, Verunreinigungen von der ebenen Oberfläche entfernt und die ebene Oberfläche mit Hafniumdiborid, Molybdändiborid, Tantaldiborid, Titandiborid, Wolframdiborid, Vanadiumdiborid, Zirkondiborid oder Mischungen dieser Stoffe in einem Flächenmagnetronsputter-Beschichtungssystem auf eine Vickershärte von mindestens 2000 HV beschichtet, indem durch Bewegen der ebenen Oberfläche und ein Sputterkopf des Flächenmagnetronsputter-Beschichtungssystems relativ zueinander mit einer Scangeschwindigkeit ausgeführt wird, die ausreicht, um in der ebenen Pressoberfläche einen thermischen Gradienten von 27,78°C oder weniger zu erzeugen.

Aus EP 1063 085 A1 ist ein Presswerkzeug gemäß dem Oberbegriff des beigefügten Anspruchs 1 bekannt.

Die Aufgabe der Erfindung ist es, ein Presswerkzeug mit einer Pressoberfläche mit bereichsweise unterschiedlichen Glanzgraden anzugeben, deren Herstellung relativ umweltfreundlich ist.

Weiters soll ein Verfahren zur Herstellung eines Presswerkzeugen gezeigt werden, welches eine leichtere Reproduzierbarkeit bei geringeren Kosten gewährleistet. Ferner soll ein Presswerkzeug zur Herstellung eines Werkstücks, insbesondere einer Werkstoffplatte, geschaffen werden, dessen Oberflächenstrukturierung unterschiedliche Strukturen, beispielsweise Grob- und Feinstrukturen, mit beliebigem Detail- und Qualitätsgrad aufweist.

Weitere Aufgaben der Erfindung gehen aus der Offenbarung dieser Anmeldung hervor.

Die Aufgabe der Erfindung wird gelöst durch ein Presswerkzeug zum Herstellen eines Werkstücks, aufweisend eine Pressoberfläche, eine Grundstruktur, und zumindest zwei auf der Oberfläche übereinander angeordnete Keramikschichten, die die Pressoberfläche bilden, von denen eine der Keramikschichten eine vollflächige Keramikschicht mit einem Glanzgrad und die andere eine partielle Keramikschicht mit einem weiteren Glanzgrad ist, der sich vom Glanzgrad der vollflächigen Keramikschicht unterscheidet.

Das erfindungsgemäße Presswerkzeug ist z.B. ein Endlosband oder eine Prägewalze. Vorzugsweise ist das das erfindungsgemäße Presswerkzeug Pressblech.

Die Pressoberfläche ist z.B. glatt, kann aber auch als eine strukturierte Pressoberfläche ausgeführt sein. Insbesondere kann somit die Pressoberfläche eine Struktur aus Erhebungen und Vertiefungen aufweisen, und die Grundstruktur eine strukturierte Oberfläche entsprechend der Struktur der Pressoberfläche oder welche Pressoberfläche durch weiteren Schichtauftrag von Schichten insbesondere Keramikschichten in Ihrer 3-dimensionaler Form abweicht.

Ein weiterer Aspekt der Erfindung ist ein Verfahren zum Herstellen des erfindungsgemäßen Presswerkzeugs, aufweisend folgende Verfahrensschritte:
- Bereitstellen einer Tragstruktur für eine Grundstruktur,
- Aufbringen von zumindest zwei Grundstrukturschichten auf die Tragstruktur zum Aufbau der Grundstruktur
- Herstellen einer strukturierten Oberfläche auf der Tragstruktur
- Auftragen einer ersten Keramikschicht auf die Oberfläche der Grundstruktur, und
- Auftragen einer zweiten Keramikschicht auf die auf der strukturierten Oberfläche und/oder auf die aufgetragene erste Keramikschicht.

Das erfindungsgemäße Presswerkzeug kann demnach die Grundstruktur, die gemäß einer Variante eine strukturierte Oberfläche entsprechend der ggf. als strukturierte Pressoberfläche ausgebildeten Pressoberfläche aufweisen. Die Grundstruktur umfasst z.B. mehrere, übereinander angeordnete partielle Metallschichten, die die Oberfläche der Grundstruktur bilden, wie es beispielsweise aus der in der Einleitung genannten WO 2009/062488 A2 bekannt ist.

Um eine relativ harte Pressoberfläche zu erhalten, kann jedoch erfindungsgemäß diese Oberfläche nicht mit einer Chromschicht versehen, sondern mit den Keramikschichten. Keramik kann ebenfalls relativ hart ausgeführt sein und kann z.B. Vickershärte von mindestens 2000 HV aufweisen. Geeignete Keramikmaterialien der Keramikschichten sind z.B. Hafniumdiborid, Molybdändiborid, Tantaldiborid, Titandiborid, Wolframdiborid, Vanadiumdiborid, Zirkondiborid oder Mischungen dieser Keramikmaterialien. Das Auftragen bzw. Beschichten der Keramikschichten ist im Vergleich zum Auftragen bzw. Beschichten mit der Chromschicht deutlich umweltschonender.

Des Weiteren kann das erfindungsgemäße Presswerkzeug zumindest zwei übereinander angeordnet Keramikschichten umfassen, vorzugsweise genau zwei übereinander angeordnete Keramikschichten. Eine der Keramikschichten ist eine partielle und die andere kann eine vollflächige Keramikschicht sein. Dadurch, dass sich erfindungsgemäß die Glanzgrade der vollflächigen von der partiellen Keramikschicht unterscheiden können, weist die Pressoberfläche in unterschiedlichen Bereichen unterschiedliche Glanzgrade auf, wodurch die Oberfläche des mit dem Pressblech hergestellt Werkstücks ebenfalls bereichsweise entsprechend unterschiedliche Glanzgrade aufweisen können. Dadurch kann die Qualität der durch Verpressen mit der Pressoberfläche entstehenden Werkstücke verbessert werden. Werkstücke sind z.B. Werkstoffplatten, insbesondere Laminate oder Paneele.

Insbesondere ist es auch möglich, eine abgenutzte oder beschädigte Keramikschicht von der Grundstruktur relativ einfach zu entfernen, um die Grundstruktur neu mit Keramikschichten zu versehen. Dadurch ergibt sich eine relativ kostengünstige Reparatur eines abgenutzten oder beschädigten Presswerkzeugs.

Das Auftragen der Keramikschichten kann z.B. mittels eines Flächenmagnetronsputter-Beschichtungssystems erfolgen.

Die Dicken der beiden Keramikschichten liegen vorzugsweise im Bereich zwischen 1µm und 2µm.

Um die unterschiedlichen Glanzgrade der vollflächigen und der partiellen Keramikschicht zu erhalten, unterscheidet sich vorzugsweise die Dicke der vollflächigen Keramikschicht von der Dicke der partiellen Keramikschicht. Es ist nämlich möglich, den Glanzgrad der entsprechenden Keramikschicht über deren Dicke einzustellen. In diesem Fall bestehen die beiden Keramikschichten vorzugsweise aus demselben Keramikmaterial, was sich positiv auf die Herstellungskosten des erfindungsgemäßen Presswerkzeugs auswirken kann. Die erforderliche Dicke der Keramikschichten kann bei der Herstellung des Pressblechs z.B. durch ein geeignetes Ansteuern des Flächenmagnetronsputter-Beschichtungssystems erfolgen.

Der Glanzgrad der beiden Keramikschichten kann auch durch die Verwendung unterschiedlicher Keramikmaterialien für die partielle und die vollflächige Keramikschicht eingestellt werden. Gemäß einer Variante des erfindungsgemäßen Pressblechs können sich daher die Keramikmaterialien der beiden Keramikschichten unterscheiden, um die unterschiedlichen Glanzgrade der vollflächigen und der partiellen Keramikschicht zu erhalten. In diesem Fall ist insbesondere die Dicke der vollflächigen Keramikschicht gleich der Dicke der partiellen Keramikschicht.

Vorzugsweise ist die partielle Keramikschicht zwischen der vollflächigen Keramikschicht und der Oberfläche des Grundstruktur angeordnet. Diese Ausführungsform des erfindungsgemäßen Pressblechs kann z.B. hergestellt werden durch
- Auftragen einer partiellen Maske auf die Oberfläche der Grundstruktur,
- Auftragen einer Keramikschicht auf der mit der Maske versehenen Oberfläche in Bereichen, die nicht von der Maske bedeckt sind,
- Entfernen der Maske, sodass auf der strukturierten Oberfläche die partielle Keramikschicht angeordnet ist, und
- Auftragen der vollflächigen Keramikschicht auf die partielle Keramikschicht.

Die partielle Keramikschicht kann aber z.B. auch durch geeignetes Ansteuern des Flächenmagnetronsputter-Beschichtungssystems hergestellt werden.

Da gemäß dieser Variante des Presswerkzeugs die vollflächige Keramikschicht auf der partiellen Keramikschicht aufgetragen ist, kann in relativ einfacher Weise eine relativ glatte Pressoberfläche hergestellt werden. In diesem Fall muss jedoch die vollflächige Keramikschicht derart beschaffen sein, dass sie den Glanzgrad der darunterliegenden partiellen Keramikschicht nicht völlig überdeckt. Insbesondere ist in diesem Fall die vollflächige Keramikschicht dünner als die partielle Keramikschicht, d.h. die Dicker der vollflächige Keramikschicht ist kleine als die Dicke der partielle Keramikschicht.

Das erfindungsgemäße Presswerkzeug kann aber auch derart ausgestaltet sein, dass die vollflächige Keramikschicht zwischen der partiellen Keramikschicht und der strukturierten Oberfläche der Grundstruktur angeordnet, d.h. dass die partielle Keramikschicht auf der vollflächigen Keramikschicht aufgetragen ist. Diese Ausführungsform des erfindungsgemäßen Presswerkzeugs kann z.B. hergestellt werden durch
- Auftragen der vollflächigen Keramikschicht auf die Oberfläche der Grundstruktur,
- Auftragen einer partiellen Maske auf die vollflächige Keramikschicht,
- Auftragen einer Keramikschicht auf der mit der Maske versehenen vollflächigen Keramikschicht in Bereichen, die nicht von der Maske bedeckt sind,
- Entfernen der Maske, sodass auf der vollflächigen Keramikschicht die partielle Keramikschicht angeordnet ist.

Die partielle Keramikschicht kann aber z.B. auch durch geeignetes Ansteuern des Flächenmagnetronsputter-Beschichtungssystems hergestellt werden.

Die Glanzgrade der partiellen und der vollflächigen Keramikschichten kann auch durch ein Nachbehandeln der entsprechenden aufgetragenen Keramikschicht erfolgen, um einen vorgegebenen Glanzgrad der entsprechenden Keramikschicht zu erhalten. Ein Nachbehandeln kann z.B. ein Polieren oder ein Laserbehandeln der entsprechenden Keramikschicht umfassen.

Gemäß einer Ausführungsform des erfindungsgemäßen Presswerkzeugs kann die die Oberfläche der Grundstruktur in unterschiedlichen Bereichen unterschiedliche Glanzgrade aufweisen, die sich insbesondere von den Glanzgraden der vollflächigen und der partiellen Keramikschicht unterscheiden. Das Einstellen der unterschiedlichen Glanzgrade der Oberfläche der Grundstruktur kann z.B. mittels eines Lasers erfolgen oder ist im Falle der Grundstruktur aus mehreren, übereinander angeordneten aus der WO 2009/062488 A2 bekannt.

Das Presswerkzeug kann gemäß der Erfindung zum Herstellen eines Werkstücks insbesondere Werkstoffplatten für die Möbelindustrie oder für Laminatfußbodenpaneele, verwendet werden. Das Presswerkzeug weist eine Pressoberfläche auf, welche beim Verpressen der Werkstoffplatte in einer Presse im direkten Kontakt mit der zu verpressenden Werkstoffplatte steht und dieser zugewandt ist.

Das Presswerkzeug weist eine Grundstruktur mit einer Oberfläche auf. Diese Oberfläche kann flach oder aber 3-dimensional ausgeformt sein. Die Oberfläche kann bevorzugt aus einer metallischen Oberfläche, wie zum Beispiel Chrom, Kupfer, Edelstahl, Nickel, Zinn oder metallischen Legierungen gebildet sein. Auf dieser Oberfläche sind Keramikschichten angeordnet, die die Pressoberfläche bilden. Eine erste Keramikschicht weist einen ersten Glanzgrad und eine zweite Keramikschicht einen zweiten Glanzgrad auf. Ein Glanzgrad kann dabei von Materialeigenschaften der Pressoberfläche, dem Schichtaufbau, der Oberflächenstruktur einer oder beider Keramikschichten oder der darunterliegenden Oberfläche der Grundstruktur bestimmt sein. Der ersten Glanzgrad der ersten Keramikschicht unterscheidet sich vom zweiten Glanzgrad. Dadurch ist es möglich eine besonders widerstandsfähige Oberfläche zu erzeugen, welche aber dennoch so ausgestalten sein kann, dass sie einer natürlichen Optik, insbesondere einer Holzoptik realitätsnah nachempfunden ist.

Bevorzugterweise ist das Presswerkzeug ein Pressblech zur Herstellung von Werkstoffplatten ist. Werkstoffplatten werden in der Möbelindustrie oder für Laminatfußbodenpaneele verwendet. Vorteilhaft bei der Anwendung eines Pressbleches ist dabei, dass dieses in bestehenden Pressanlagen der Möbel. Und Fußbodenindustrie eingesetzt werden kann.

In einem weiteren Ausführungsbeispiel kann die Grundstruktur des Presswerkzeuges eine Tragstruktur aus Metall, insbesondere Edelstahl aufweisen. Eine metallische Tragstruktur gewährleistet eine gleichmäßige Verteilung des Pressdruckes auf die zu verpressende Werkstoffplatte und ist verschleißbeständig.

Bevorzugt kann es sein, dass die Pressoberfläche eine Struktur aus Erhebungen und Vertiefungen aufweist, und die Grundstruktur eine auf der Tragstruktur vorgesehene strukturierte Oberfläche aufweist, wobei auf der Tragstruktur zumindest zwei, zumindest teilweise übereinander angeordnete Grundstrukturschichten insbesondere aus Metall vorgesehen sind, die die strukturierte Oberfläche der Grundstruktur bilden. Diese Grundstrukturschichten können flach oder über ein additives Fertigungsverfahren, in 3-dimensionaler Form aufgebracht sein. Additive Fertigungsverfahren können beispielsweise Tintenstrahldruck, 3-D Druck, Sintern, Lithographie, Lackieren, Druck mit UV-härtender Tinte oder Acrylat sein. Besonders vorteilhaft ist dabei, dass für Zwischenlagen der Grundstrukturschicht günstigere Materialien und schnellere und unpräzisere Auftragverfahren verwendet werden können. Dies ermöglicht eine kostengünstigere Herstellung bei hoher Oberflächengüte an Pressoberfläche.

Des Weiteren kann es zweckmäßig sein, wenn die erste oder die zweite Keramikschicht auch nur partiell auf der strukturierten Oberfläche der Grundstruktur aufgebracht sein können und so eine Reliefschichtstruktur der strukturierten Oberfläche bilden. Dies ermöglich eine weitere Feinstrukturierung der Reliefschichtstruktur bei gleichzeitig höher Widerstandsfähigkeit der Keramikschichten und/oder die Erzielung besonderer optischer Effekte.

Darüber hinaus kann vorgesehen sein, dass die erste Keramikschicht und die zweite Keramikschicht beispielsweise aber auch jeweils nur partiell auf der strukturierten Oberfläche der Grundstruktur aufgebracht sein können. Dies ermöglich eine weitere Feinstrukturierung der Reliefschichtstruktur bei gleichzeitig höher Widerstandsfähigkeit der Keramikschichten und/oder die Erzielung besonderer optischer Effekte zum Beispiel unterschiedliche Glanzgrade oder Mattigkeiten in den partiell aufgebrachten Bereichen.

In einer Weiterbildung kann die zweite Keramikschicht zumindest teilweise auf der ersten Keramikschicht angeordnet sein. So können Bereiche mit unterschiedlichen Oberflächen Eigenschaften und unterschiedlicher Struktur entstehen. Ebenso kann dies zur Ausformung einer Reliefschichtstruktur beitragen.

Bevorzugterweise kann die erste Keramikschicht oder die zweite Keramikschicht zumindest in einem Laserbearbeitungsbereich mittels eines Lasers bearbeitet sein. Durch eine Laserbearbeitung kann eine Veränderung des Glanzgrades, der Mattigkeit, der Struktur oder ein Ausschnitt in einer darüberliegenden Schicht an der Pressoberfläche herstellbar sein.

In der zweiten Keramikschicht kann eine Aussparung vorgesehen sein, die in Richtung der Grundstruktur betrachtet, bis zur ersten Keramikschicht reicht. Bei der Betrachtung der Pressoberfläche ergeben sich so zumindest zwei unterschiedlich erscheinende oder unterschiedlich strukturierte Bereiche.

Bevorzugterweise kann die Aussparung eine durch nachfolgende Bearbeitung der aufgebrachten zweiten Keramikschicht erzeugter Ausschnitt sein. Mögliche Bearbeitungsschritte können dabei Fräsen, Laserbestrahlung, Maskieren, Maskieren mit UV härtender Farbe und Entfernen bzw. Ätzen oder Cracken mittels Lauge oder Säure. Zum Entfernen kann dabei zum Beispiel eine wasserstoffperoxidhaltige Natronlauge verwendet werden. Diese Ausschnitte ermöglichen einen Auftrag über die gesamte Fläche und die Ermöglichung darunterliegende Schichten sichtbar oder optisch wirksam zu machen.

Ferner kann es zweckmäßig sein, wenn die nachfolgende Bearbeitung eine Laserbearbeitung sein. Dabei ist es von Vorteil, dass eine Laserbearbeitung eine sehr genaue und feine Bearbeitung auch in der Tiefe der Schichten ermöglicht.

In einer weiteren möglichen Ausführung der Erfindung kann eine der an der Pressseite der Grundstruktur angeordneten Metallschichten, eine Nickelschicht oder nickelhaltige Metallschicht sein. An der Pressseite darüberliegend können die erste und/oder die zweite Keramikschicht angeordnet sein. Zwischen der ersten und der zweiten Keramikschicht kann zusätzlich eine Metallschichten, eine Nickelschicht oder nickelhaltige Metallschicht angeordnet sein. Diese Metallschichten ermöglichen die Anbringung weitere Schichten in Ihrer Funktion als Verbindungsschicht.

In einer weiteren möglichen Ausführungsform ist die strukturierte Oberfläche der Grundstruktur zumindest teilweise in 3-dimensionaler Reliefschichtstruktur mit einem additiven Fertigungsverfahren hergestellt. Additive Fertigungsverfahren können beispielsweise Tintenstrahldruck, 3-D Druck, Sintern, Lithographie, Lackieren, Druck mit UV-härtender Tinte oder Acrylat sein. Derartige Fertigungsverfahren ermöglichen kleine Losgrößen und die Verwirklichung individueller Strukturwünsche der Möbelindustrie.

Alternativ dazu kann die strukturierte Oberfläche der Grundstruktur zumindest teilweise in 3-dimensionaler Form mit einem elektrochemischen, mechanischen oder Laser-Bearbeitungsverfahren hergestellt sein. Hierbei können zum Beispiel aus dem Stand der Technik bekannte Maskierungs- und Ätzverfahren, oder elektrochemische Verchromungsverfahren zum Einsatz kommen. Erprobte Verfahren können dabei mit den erfindungsgemäßen Verbesserungen gemeinsam am Presswerkzeug eingesetzt werden und so die Einsatzvielfalt erhöhen.

Die zweite Keramikschicht kann optional vollflächig die strukturierte Oberfläche der Grundstruktur (10) bedecken und eine Dicke von bevorzugt 0,001 mm bis 2 mm aufweisen, wobei die erste Keramikschicht eine andere Dicke aufweist, bevorzugt aber auch bevorzugt im Bereich von 0,001 mm bis 2 mm. Die Unterschiede in der Schichtdicke führen zu einer veränderten Struktur und damit zu unterschiedlichen Glanzgrade der ersten und der zweiten Keramikschicht, wobei insbesondere die beiden Keramikschichten aus demselben Keramikmaterial bestehen können. Die unterschiedlichen Schichtdicken können dabei zur Erzielung optischer Effekte eingesetzt werden.

Alternativ dazu kann sich das Keramikmaterial der beiden Keramikschichten auch unterscheiden, um die unterschiedlichen Glanzgrade der ersten Keramikschicht und der zweiten Keramikschicht zu erhalten, wobei insbesondere die Dicke der zweiten Keramikschicht gleich der Dicke der ersten Keramikschicht sein kann. Der Einsatz von unterschiedlichen Keramikschichten erhöht weiter die optischen und kombinatorischen Möglichkeiten zur Erzielung einer naturgetreuen Imitation von natürlichen Werkstoffen

Als Keramikmaterial der Keramikschichten können beispielsweise folgende Materialien Anwendung finden: Hafniumdiborid, Molybdändiborid, Tantaldiborid, Titandiborid, Wolframdiborid, Vanadiumdiborid, Zirkondiborid oder Mischungen dieser Keramikmaterialien. Vorteilhaft an diesen Materialien ist Ihre Widerstandsfähigkeit und Härte welche zu verbesserten Verpressungseigenschaften des Presswerkzeuges führt.

Eine Ausführungsform des erfindungsgemäßen Presswerkzeugs wird hergestellt durch
- Bereitstellen einer Tragstruktur für eine Grundstruktur,
- Aufbringen von zumindest zwei Grundstrukturschichten auf die Tragstruktur zum Aufbau der Grundstruktur
- Herstellen einer strukturierten Oberfläche auf der Tragstruktur
- Auftragen einer ersten Keramikschicht auf die Oberfläche der Grundstruktur, und
- Auftragen einer zweiten Keramikschicht auf die auf der strukturierten Oberfläche und/oder auf die aufgetragene erste Keramikschicht.

Dadurch ist es möglich eine besonders widerstandsfähige Oberfläche zu erzeugen, welche aber dennoch so ausgestalten sein kann, dass sie einer natürlichen Optik, insbesondere einer Holzoptik realitätsnah nachempfunden ist.

In einer weiteren vorteilhaften Fortbildung kann das Verfahren folgende Schritte aufweisen:
- Auftragen einer partiellen Maske auf die strukturierte Oberfläche der Grundstruktur,
- Auftragen einer ersten Keramikschicht auf der mit der Maske versehenen strukturierten Oberfläche,
- Entfernen der Maske, sodass auf der strukturierten Oberfläche die erste Keramikschicht nur partiell angeordnet ist, und
- vollflächiges Auftragen der zweiten Keramikschicht auf die partiell aufgetragene erste Keramikschicht und die strukturierte Oberfläche der Grundstruktur.

Von Vorteil ist dabei, dass einzelne Bereiche auf dem Presswerkzeug andere optische Eigenschaften, wie Glanzgrade aufweisen können und die Fertigung dennoch einfach und Maskierungsverfahren erprobt sind.

In einer alternativen Ausführung kann das Verfahren folgende Schritte aufweisen:
- vollflächiges Auftragen der ersten Keramikschicht auf die strukturierte Oberfläche der Grundstruktur.
- Auftragen einer partiellen Maske auf die ersten Keramikschicht,
- Auftragen der zweiten Keramikschicht auf der mit der Maske versehenen ersten Keramikschicht

Vorteilhaft ist dabei, dass einzelne Bereiche auf dem Presswerkzeug andere optische Eigenschaften, wie Glanzgrade aufweisen können und auch zur gesamten Reliefstruktur des Presswerkzeuges beitragen.

Optional kann dabei ein Entfernen der Maske erfolgen, sodass auf der strukturierten Oberfläche die erste Keramikschicht nur partiell angeordnet ist.

In einer weiteren optionalen Verfahrensführung kann als Maske eine Metallschicht, eine Chromschicht, eine Nickelschicht oder nickelhaltige Metallschicht aufgetragen werden.

Dabei kann vorteilhafterweise die Maske als funktionale Schicht am Presswerkzeug verbleiben.

Das erfindungsgemäße Verfahren kann durch den Schritt einer Nachbehandlung ergänzt sein, bei der die entsprechende aufgetragene Keramikschicht oder Maske so behandelt wird, um einen vorgegeben Glanzgrad der entsprechenden Keramikschicht oder Maske zu erhalten.

Das Auftragen der Keramikschichten kann in einer Ausführungsform mittels eines Flächenmagnetronsputter-Beschichtungssystems erfolgen, wobei das partielle Herstellen der Keramikschicht durch geeignetes Ansteuern des Flächenmagnetronsputter-Beschichtungssystems geschieht. Dadurch wird ein kohärenter und in seiner Schichtstärke genau steuerbarer oder regelbarer Auftrag der Keramikschichten gewährleistet.

Dabei kann das erfindungsgemäße Verfahren so fortgebildet sein, dass folgende Schritte zusätzlich durchgeführt werden:
- Transport des Pressbleches auf einem Transportsystem
- Öffnen einer ersten Schleuse zum Bearbeitungsraum
- Transport des Pressbleches in den Bearbeitungsraum des Flächenmagnetronsputter-Beschichtungssystems
- Schließen der ersten Schleuse
- Anlegen eines Vakuums im Bearbeitungsraum mittels einer Vakuumpumpe)
- Auftragen einer oder mehrerer Keramikschichten mittels eines Magnetrons
- Öffnen der ersten Schleuse zum Bearbeitungsraum
- Transport des Pressbleches durch die erste Schleuse aus dem Bearbeitungsraum des Flächenmagnetronsputter-Beschichtungssystems heraus.

Durch diese vorteilhafte Weiterbildung ist eine kostengünstige Fertigung des Presswerkzeuges realisierbar.

Das erfindungsgemäße Verfahren kann folgende zusätzlichen Schritte umfassen:
- Transport des Pressbleches durch eine Vakuumvorkammer mit einer Vorkammerschleuse welche Vakuumvorkammer dem Bearbeitungsraum in Transportrichtung gesehen vorgelagert ist, wobei die Vakuumvorkammer mittels einer Vakuumpumpe auf ein Druckniveau gebracht wird welches zwischen dem Atmosphärendruck und einem Bearbeitungsdruck während dem Auftragen einer Keramikschicht im Bearbeitungsraum liegt, wobei dieser Bearbeitungsdruck insbesondere unter 10^-5 mbar, bevorzugt bei 10^-8 mbar liegt.

Durch diese vorteilhafte Prozessverbesserung ist eine energieeffiziente Beschichtung gewährleistet.

Das erfindungsgemäße Verfahren kann alternativ die zusätzlichen Schritte umfassen:
- Transport des Pressbleches durch eine Vakuumvorkammer mit einer Vorkammerschleuse welche Vakuumvorkammer dem Bearbeitungsraum in Transportrichtung gesehen vorgelagert ist, wobei die Vakuumvorkammer mittels einer Vakuumpumpe auf ein Druckniveau gebracht wird, welches zwischen dem Atmosphärendruck und einem Bearbeitungsdruck, während dem Auftragen einer Keramikschicht im Bearbeitungsraum liegt, wobei dieser Bearbeitungsdruck insbesondere unter 10^-5 mbar, bevorzugt bei 10^-8 mbar liegt.
- Transport des Pressbleches durch eine Vakuumnachkammer mit einer Nachkammerschleuse, welche Vakuumnachkammer dem Bearbeitungsraum in Transportrichtung gesehen nachgelagert ist, wobei die Vakuumnachkammer mittels einer Vakuumpumpe auf ein Druckniveau gebracht wird, welches zwischen dem Atmosphärendruck und dem Bearbeitungsdruck liegt. Vorteilhafterweise ist so eine optimierte Bearbeitung unter Einsatz geringer Energiemengen zur Vakuumerzeugung möglich.

Ein weiterer Aspekt der Erfindung ist die Verwendung eines erfindungsgemäßen Presswerkzeuges zur Herstellung von Werkstoffplatten, insbesondere Werkstoffplatten für die Möbelindustrie oder für Laminatfußbodenpaneele. Vorteilhaft können mit dem erfindungsgegenständlichen Presswerkzeug große Mengen von Werkstoffplatten, insbesondere Werkstoffplatten für die Möbelindustrie oder für Laminatfußbodenpaneele bei geringem Verschleiß hergestellt werden.

Ausführungsbeispiele der Erfindung sind exemplarisch in den beigefügten schematischen Figuren dargestellt. Es zeigen:
- Fig. 1: ein Pressblech mit einer Pressoberfläche in einer perspektivischen Darstellung,
- Fig. 2: einen Ausschnitt einer Seitenansicht des Pressblechs in geschnittener Darstellung,
- Fig. 3: Zwischenstadien des Pressblechs während seiner Herstellung,
- Fig. 4: einen Ausschnitt einer Seitenansicht des Pressblechs in geschnittener Darstellung einer alternativen Ausführungsform,
- Fig. 5: einen Ausschnitt einer Seitenansicht des Pressblechs in geschnittener Darstellung einer weiteren alternativen Ausführungsform,
- Fig. 6: einen Ausschnitt einer Seitenansicht des Pressblechs mit einem Laminat während eines Pressvorganges in einer geschlossenen Presse in geschnittener Darstellung,
- Fig. 7: Seitenansicht Flächenmagnetronsputter-Beschichtungssystem in geschnittener Darstellung.

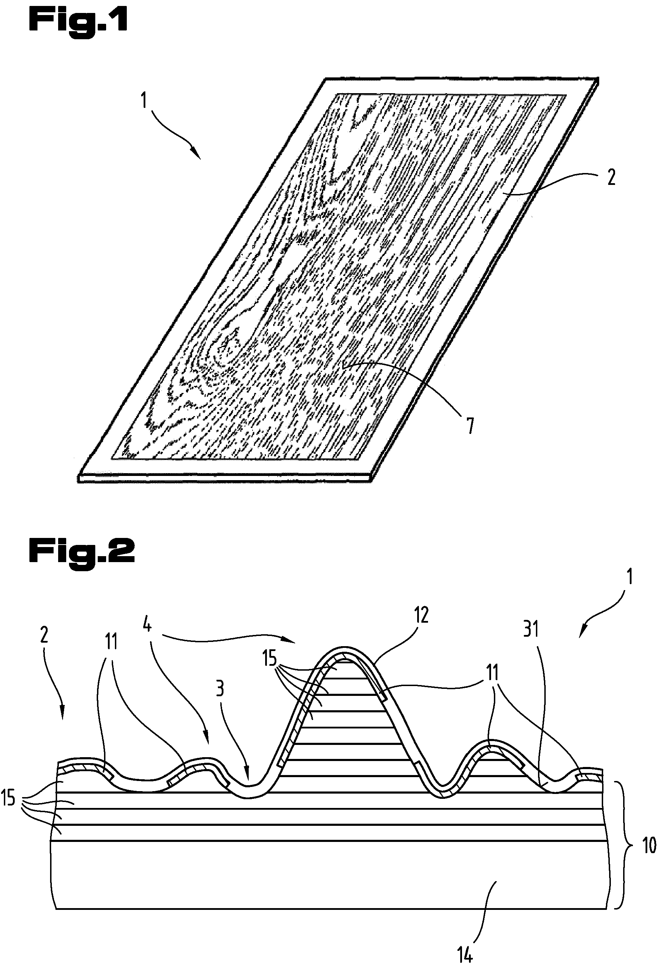

Die Fig. 1 zeigt in einer perspektivischen Darstellung ein Presswerkzeug, das im Falle des vorliegenden Ausführungsbeispiels als ein Pressblech 1 ausgebildet ist Das Pressblech 1 umfasst eine Pressoberfläche 2. Die Pressseite 3 ist jene Seite des Pressbleches 1 welche dem Laminat während eines Pressvorganges in einer Presse zugewandt ist.

Die Fig. 2 zeigt einen Ausschnitt einer Seitenansicht des Pressblechs 1 in geschnittener Darstellung.

Die Pressoberfläche 2 kann glatt ausgeführt sein, umfasst jedoch im Falle des vorliegenden Ausführungsbeispiels eine Struktur aus den Erhebungen 4 und Vertiefungen 3.

Die Struktur der Pressoberfläche 2 ist insbesondere einem natürlichen Werkstoff, im Falle des vorliegenden Ausführungsbeispiels Holz zugeordnet.

Die Pressoberfläche 2 ist auf mehreren Grundstrukturschichten 15 der Grundstruktur 10 angeordnet. Die Grundstruktur 10 umfasst neben den Grundstrukturschichten 15 auch die Tragstruktur.

Die erste Keramikschicht 11 ist in diesem Ausführungsbeispiel partiell auf der Grundstruktur 10 angeordnet und die zweite Keramikschicht 12 bedeckt die Oberfläche 31 der Grundstruktur 10 und die erste Keramikschicht 11 vollflächig.

Mit dem Pressblech 1 kann ein Werkstück, z.B. eine Werkstoffplatte, beispielsweise ein Laminat, durch Verpressen hergestellt werden. Nach dem Verpressen weist das Werkstück eine der Struktur der Pressoberfläche 2 entsprechende strukturierte Oberfläche auf.

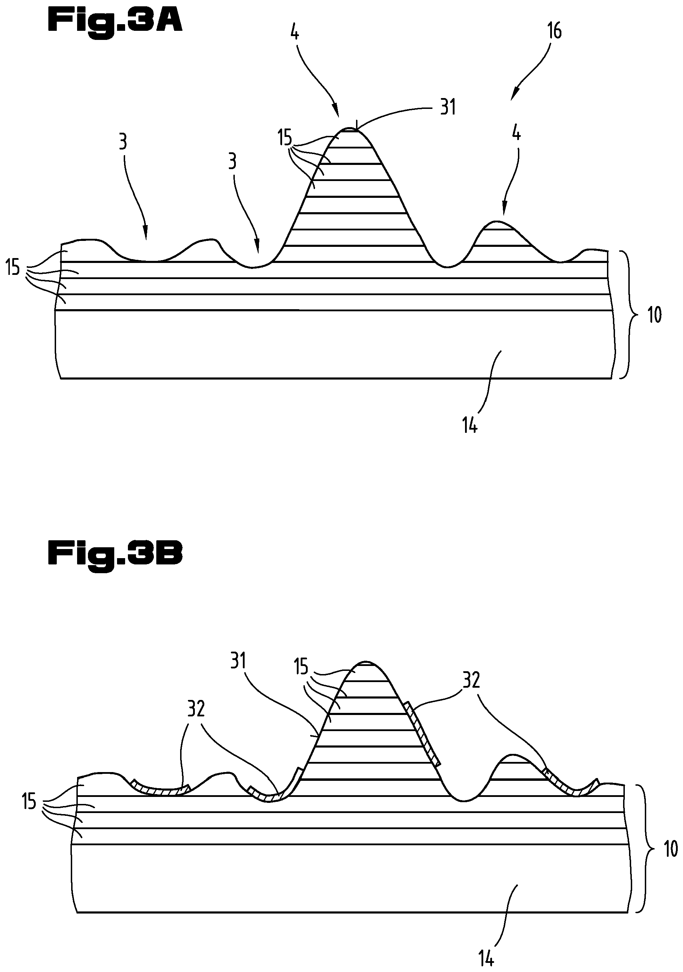

Das Pressblech 1 umfasst im Falle des vorliegenden Ausführungsbeispiels eine in der Fig. 3A gezeigte Grundstruktur 10 mit einer der Struktur der Pressoberfläche 2 zugeordneten strukturierten Oberfläche 31.

Das Pressblech 1 umfasst im Falle des vorliegenden Ausführungsbeispiels eine auf der strukturierten Oberfläche 31 der Grundstruktur 10 angeordnete partielle Keramikschicht 11 und eine auf der partiellen Keramikschicht 11 angeordnete vollflächige Keramikschicht 12, die die Pressoberfläche 2 bildet.

Die Grundstruktur 10 ist im Falle des vorliegenden Ausführungsbeispiels aus Metall.

Im Falle des vorliegenden Ausführungsbeispiels umfasst das Pressblech 1 einen Grundträger, insbesondere eine Tragstruktur 14 z.B. aus Metall, auf der die Grundstruktur 10 angeordnet ist.

Im Falle des vorliegenden Ausführungsbeispiels umfasst die Grundstruktur 10 mehrere, übereinander liegende Grundstrukturschichten 15. Die Grundstrukturschichten 15 sind vorzugsweise aus Nickel und sind zumindest teilweise partiell ausgeführt und bilden gemeinsam mit den Keramikschichten 11,12 die Reliefschichtstruktur 16.

Die Grundstruktur 10 kann z.B. hergestellt werden, indem eine nicht näher dargestellt Maske zumindest einmal auf eine Grundstrukturschicht 15 in Abhängigkeit von der Struktur der strukturierten Pressoberfläche 2 zugeordneten Bilddaten aufgetragen wird, um Bereiche abzudecken, und anschließend eine weitere Grundstrukturschicht 15 auf die von dieser Maske nicht abgedeckten Bereiche aufgetragen wird. Dies wird wiederholt, bis die Grundstruktur 10 entstanden ist. Die Grundstruktur 10 wird insbesondere in Abhängigkeit von der Struktur der Pressoberfläche 2, d.h. in Abhängigkeit der Erhebungen 4 und Vertiefungen 5 zugeordneten Bilddaten hergestellt, indem in Abhängigkeit dieser Bilddaten die Masken und die Grundstrukturschichten 15 z.B. mittels eines galvanischen oder chemischen Verfahrens nacheinander aufgetragen werden.

Auf die strukturierte Oberfläche 31 der Grundstruktur 10 wird anschließend im Falle des vorliegenden Ausführungsbeispiels eine in der Fig. 3B gezeigte Maske 32 aufgetragen, die die strukturierte Oberfläche 31 der Grundstruktur 10 partiell bedeckt.

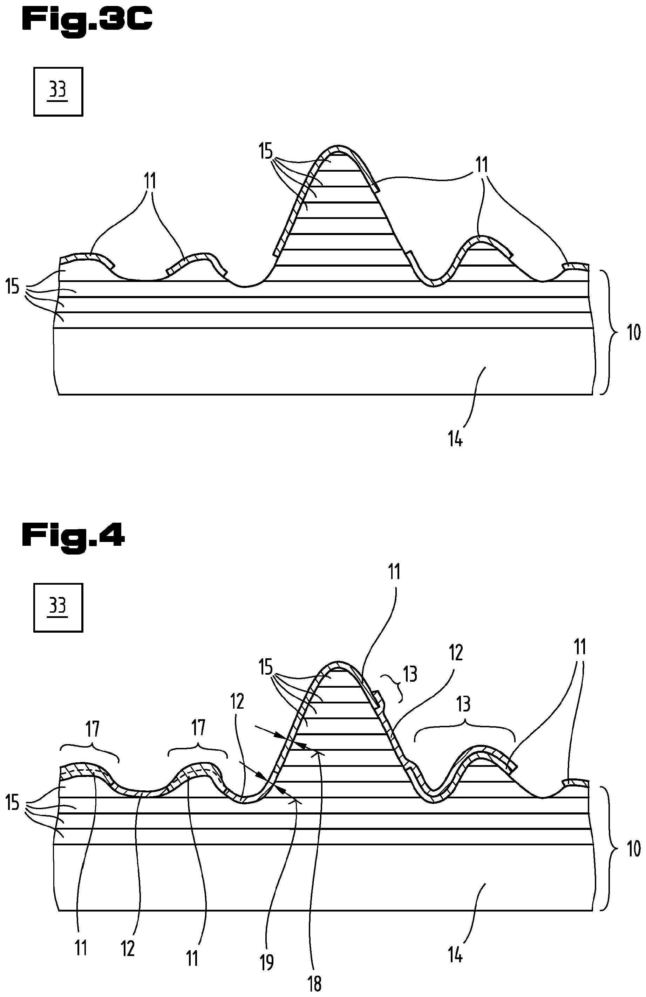

Anschließend wird im Falle des vorliegenden Ausführungsbeispiels mittels eines Flächenmagnetronsputter-Beschichtungssystems 33 auf die von der Maske 32 nicht bedeckten Bereiche der strukturierten Oberfläche 31 der Grundstruktur 10 eine Keramikschicht aufgetragen. Anschließend wird die Maske 32 entfernt, sodass lediglich die nicht von der Maske 32 bedeckten Bereiche der strukturierten Oberfläche 31 der Grundstruktur 10 mit der Keramikschicht bedeckt sind, wodurch die partielle Keramikschicht 11 entsteht, siehe Fig. 3c. Durch geeignetes Ansteuern des Flächenmagnetronsputter-Beschichtungssystems 33 erhält die partielle Keramikschicht 11 eine vorgegebene Dicke, wodurch sie einen vorgegebenen Glanzgrad erhält.

Anschließend wird im Falle des vorliegenden Ausführungsbeispiels mittels des Flächenmagnetronsputter-Beschichtungssystems 33 die vollflächige Keramikschicht 12 auf die partielle Keramikschicht 11 aufgetragen. Um den Glanzgrad der vollflächigen Keramikschicht 12 einzustellen, erhält diese, gesteuert durch das Flächenmagnetronsputter-Beschichtungssystem 33, eine vorgegebene Dicke.

Im Falle des vorliegenden Ausführungsbeispiels sind die beiden Keramikschichten 11, 12 aus demselben Keramikmaterial, z.B. aus Hafniumdiborid, Molybdändiborid, Tantaldiborid, Titandiborid, Wolframdiborid, Vanadiumdiborid, Zirkondiborid oder Mischungen dieser Keramikmaterialien.

Damit die Keramikschichten 11, 12 unterschiedliche Glanzgrade aufweisen, unterscheiden sich im Falle des vorliegenden Ausführungsbeispiels die Dicken der beiden Keramikschichten. Insbesondere ist die vollflächige Keramikschicht 12 dünner als die partielle Keramikschicht 11. Insbesondere bestehen die beiden Keramikschichten 11,12 aus demselben Keramikmaterial.

Die Dicken der beiden Keramikschichten 11, 12 liegen vorzugsweise im Bereich zwischen 1µm und 2µm.

Die Keramikschichten weisen vorzugsweise Vickershärte von mindestens 2000 HV auf.

Um unterschiedliche Glanzgrade der Keramikschichten 11, 12 einzustellen, können diese auch unterschiedliche Keramikmaterialien aufweisen.

Um die Glanzgrade der Keramikschichten 11, 12 einzustellen, können diese auch einer Nachbehandlung z.B. einem Polieren oder einer Laserbehandlung unterzogen werden.

Es ist auch möglich, die strukturierte Oberfläche 31 der Grundstruktur 10 zunächst mit der vollflächigen Keramikschicht 12 zu versehen und auf diese die partielle Keramikschicht 11 aufzutragen.

Es ist auch möglich, die partielle Keramikschicht 11 durch geeignetes Ansteuern des Flächenmagnetronsputter-Beschichtungssystems 33 herzustellen Fig. 4 zeigt einen Ausschnitt einer Seitenansicht des Pressblechs in geschnittener Darstellung einer alternativen Ausführungsform. Die erste Keramikschicht 11 und die zweite Keramikschicht 12 sind jeweils nur partiell auf der strukturierten Oberfläche 31 der Grundstruktur 10 aufgebracht sind. Die Grundstrukturschichten 15 können wie auch in den übrigen Ausführungsbeispielen metallisch, insbesondere aus Nickel, aber auch aus anderen Materialien wie zum Beispiel Kunststoff oder Keramik bestehen. Die Grundstrukturschichten 15 können mit bekannten additiven oder abtragenden Herstellungsverfahren aufbracht sein.

In einer weiteren vorteilhaften Weiterbildung dieses Ausführungsbeispiels kann die zweite Keramikschicht 12 zumindest teilweise auf der ersten Keramikschicht 11 angeordnet sind.

Auch kann die erste Keramikschicht 11 oder die zweite Keramikschicht 12 zumindest in einem Laserbearbeitungsbereich 17 mittels eines Lasers bearbeitet sein. Die Bearbeitung durch einen Laser kann insbesondere dazu dienen den Glanzgrad, die Reflexionseigenschaften, die Mattigkeit oder die Struktur der Keramikschicht zu beeinflussen und damit auf das herzustellende Laminat als Positiv diesen strukturellen Eigenschaften zu übergeben.

In einer weiteren Ausführungsform nach Figur 4. Kann die zweite Keramikschicht 12 vollflächig die strukturierte Oberfläche 31 der Grundstruktur 10 bedecken und eine zweite Dicke 19 aufweisen, wobei die erste Keramikschicht 11 eine erste Dicke 18 aufweist. Die erste Dicke 18 und die zweite Dicke 19 können dabei eine unterschiedliche Schichtdicke aufweisen, um die unterschiedlichen Glanzgrade der ersten und der zweiten Keramikschicht 11, 12 zu erhalten, wobei insbesondere die beiden Keramikschichten 11, 12 aus demselben Keramikmaterial bestehen können.

Das Keramikmaterial der Keramikschichten 11, 12 in allen Ausführungsbeispieles diese Erfindung kann zum Beispiel aus Hafniumdiborid, Molybdändiborid, Tantaldiborid, Titandiborid, Wolframdiborid, Vanadiumdiborid, Zirkondiborid oder aus Mischungen dieser Keramikmaterialien bestehen.

In einem weiteren Ausführungsbeispiel nach Figur 4. Kann sich das Keramikmaterial der beiden Keramikschichten 11, 12 unterscheiden, um unterschiedliche Glanzgrade der ersten Keramikschicht 11 und der zweiten Keramikschicht 12 zu erhalten, wobei insbesondere die Dicke 19 der zweiten Keramikschicht 12 gleich der Dicke 18 der ersten Keramikschicht 11 ist.

Die Dicken der beiden Keramikschichten 11, 12 liegen vorzugsweise im Bereich zwischen 1µm und 2mm.

In Überdeckungsbereichen 13 können die beiden Keramikschichten zumindest teilweise übereinander angeordnet sein.

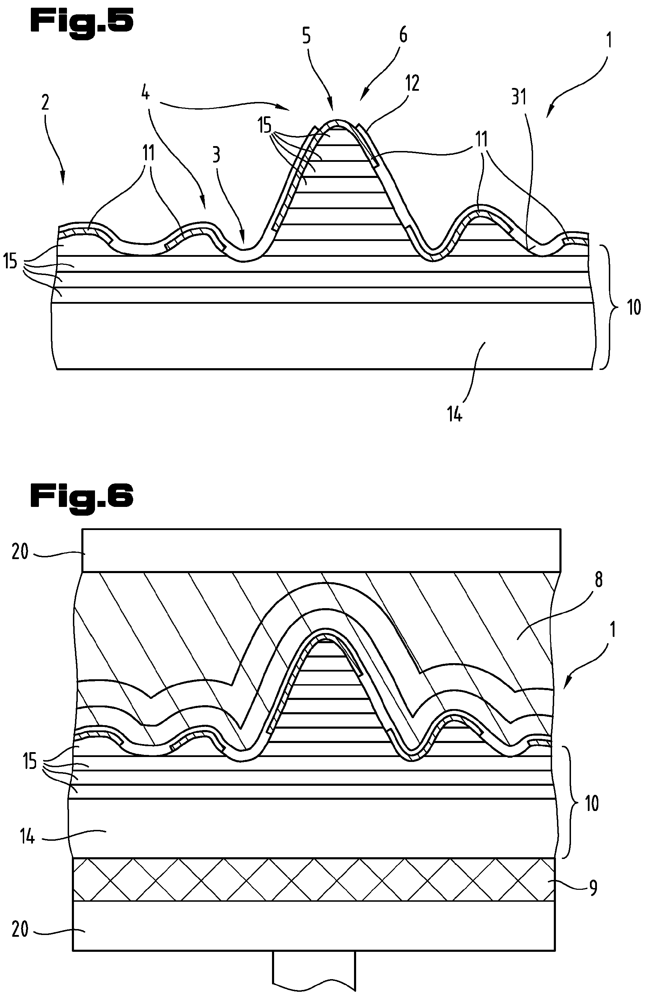

Fig. 5 zeigt einen Ausschnitt einer Seitenansicht des Pressblechs in geschnittener Darstellung einer weiteren alternativen Ausführungsform, bei welcher die beiden Keramikschichten 11,12 zumindest teilweise übereinander angeordnet sind. Die auf der Pressseite 7 des Presswerkzeuges angeordnete zweite Keramikschicht 12 weist dabei zumindest eine Aussparung 5 auf die die erste Keramikschicht an die Oberfläche treten lassen, bzw. einen Ausschnitt 6 gleich einem Fenster dazu eröffnen. Die Herstellung kann dabei unter Nutzung von Masken 32 bei der Aufbringung der Keramikschicht 12 und nachfolgende Entfernung der Maske 32 erfolgen oder durch Entfernung eines Teiles der zweiten Keramikschicht 12 über ein chemisches Verfahren zum Beispiel unter Nutzung von wasserstoffperoxidhaltiger Natronlauge.

Im Übrigen basiert die Grundstruktur auf dem Ausführungsbeispielen der Figuren 2 und 3 oder 4.

Fig. 6 zeigt einen Ausschnitt einer Seitenansicht des Pressblechs mit einem Laminat während eines Pressvorganges in einer geschlossenen Presse in geschnittener Darstellung. Das Presswerkzeug insbesondere einer Pressblech 1 ist auf einem Presspolster 9 in einer Presse 20 zum Beispiel einer Kurztaktpresse, platziert. Während des dargestellten Pressvorganges mit geschlossenen Teilen der Presse 20 wird ein Laminat 8, insbesondere eine Werkstoffplatte für die Möbelindustrie oder Fußbodenpaneele unter Temperatur und Druckeinwirkung verschmolzen und die Negativform der Pressoberfläche 2 mit ihren Vertiefungen 3 und Erhebungen 4 bildet sich als Positiv im Laminat 8 ab.

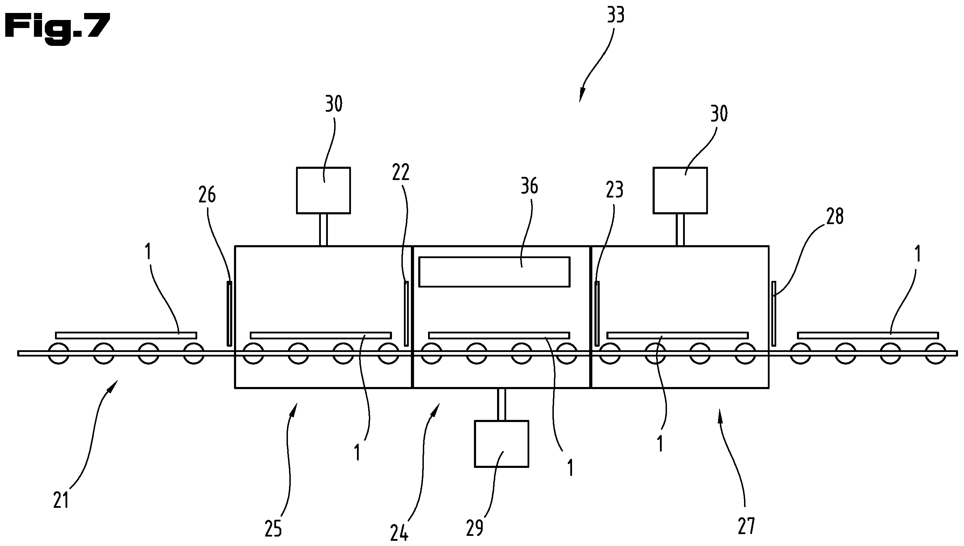

Fig. 7 zeigt eine Seitenansicht eines Flächenmagnetronsputter-Beschichtungssystem 33 in geschnittener Darstellung.

In diesem Ausführungsbeispiel ist ein Flächenmagnetronsputter-Beschichtungssystem 33 gezeigt welches ein Mehrkammersystem aufweist.

Alternativ dazu ist jedoch auch ein Einkammersystem mit nur einem Bearbeitungsraum 24 ohne weiter Kammern möglich.

Ein Presswerkzeug insbesondere ein Pressblech 1 wird mittels eines Transportsystems 21 bei geöffneter Vorkammerschleuse 26 in eine Vakuumvorkammer 25 eingebracht. Die Vorkammerschleuse 26 wird geschlossen und die Vakuumpumpe 30 senkt den Druck in der Vakuumvorkammer 25 ab. Beispielsweise auf einen Druck von unter 10^-2 mbar, bevorzugt bei 10^-5 mbar. Währenddessen ist die Schleuse 22 geschlossen und im Bearbeitungsraum herrscht ein Bearbeitungsdruck. Anschließend wird die Schleuse 22 geöffnet und der Druck passt sich zwischen dem Bearbeitungsraum 24 und der Vakuumvorkammer 25 an. Dadurch kann im Vergleich zu einem Einkammersystem Energie gespart und Taktzeit gewonnen werden. Das Presswerkzeug wird in den Bearbeitungsraum 24 gefördert. Die Schleusen 22 und 23 sind geschlossen, Vakuum wird durch die Vakuumpumpe 29 im Bearbeitungsraum angelegt. Der Bearbeitungsdruck liegt dabei unter 10^-5 mbar, bevorzugt bei 10^-8 mbar. Nach Abschluss des Bearbeitungsvorganges wird das Presswerkzeug durch die geöffnete Schleuse 23 in die Vakuumnachkammer gefördert. Dort herrscht ein mit der Vakuumvorkammer vergleichbares Druckniveau, bevor die Nachkammerschleuse geöffnet wird. Die Vakuumvorkammer und die Vakuumnachkammer können über Vakuumleitungen mit Ventilen miteinander verbunden sein, um in einem kontinuierlichen Betrieb Flächenmagnetronsputter-Beschichtungssystem 33 bei einem Taktwechsel Vakuum zwischen der Vakuumvorkammer und der Vakuumnachkammer auszutauschen und so Energie für den Betrieb der Vakuumpumpen 30 sparen. Es ist für alle erfindungsgegenständlichen Ausführungsbeispiele möglich anstatt eines Flächenmagnetronsputter-Beschichtungssystem andere PVD-Beschichtungssysteme, PVD-Sputteranlagen, Magnetronsputterranlagen oder ähnliche Anlagen zu verwenden.

### Bezugszeichenaufstellung

- 1: Pressblech
- 2: Pressoberfläche
- 3: Vertiefungen
- 4: Erhebungen
- 5: Aussparung
- 6: Ausschnitt
- 7: Pressseite
- 8: Werkstoffplatte
- 9: Presspolster
- 10: Grundstruktur
- 11: Keramikschicht
- 12: Keramikschicht
- 13: Überdeckungsbereich
- 14: Tragstruktur
- 15: Grundstrukturschicht
- 16: Reliefschichtstruktur
- 17: Laserbearbeitungsbereich
- 18: Dicke (der ersten Keramikschicht)
- 19: Dicke (der zweiten Keramikschicht)
- 20: Presse
- 21: Transportsystem
- 22: Schleuse
- 23: Schleuse
- 24: Bearbeitungsraum
- 25: Vakuumvorkammer
- 26: Vorkammerschleuse
- 27: Vakuumnachkammer
- 28: Nachkammerschleuse
- 29: Vakuumpumpe
- 30: Vakuumpumpe
- 31: Oberfläche (der Grundstruktur 10)
- 32: Maske
- 33: Flächenmagnetronsputter-Beschichtungssystem
- 34: Metallschicht
- 35: Funktionale Schicht
- 36: Magnetron

## Patentansprüche

1. Presswerkzeug zum Herstellen eines Werkstücks, aufweisend eine Pressoberfläche (2),
eine Grundstruktur (10), die eine Oberfläche (31) aufweist, und
zumindest zwei auf der Oberfläche (31) angeordnete Keramikschichten (11, 12), die die Pressoberfläche (2) bilden, **gekennzeichnet dadurch, dass**
eine erste Keramikschicht (11) einen ersten Glanzgrad und eine zweite Keramikschicht (12) einen zweiten Glanzgrad aufweist, der sich vom ersten Glanzgrad der ersten Keramikschicht (11) unterscheidet.

2. Presswerkzeug nach Anspruch 1, wobei das Presswerkzeug ein Pressblech (1) zur Herstellung einer Werkstoffplatte (8) ist.

3. Presswerkzeug nach Anspruch 1 oder 2, wobei die Grundstruktur (10) des Presswerkzeuges eine Tragstruktur (14) aus Metall insbesondere Edelstahl aufweist.

4. Presswerkzeug nach einem der Ansprüche 1 bis 3, wobei die Pressoberfläche (2) eine Struktur aus Erhebungen (4) und Vertiefungen (3) aufweist, und die Grundstruktur (10) eine auf der Tragstruktur (14) vorgesehene strukturierte Oberfläche (31) aufweist, wobei auf der Tragstruktur (14) zumindest zwei, zumindest teilweise übereinander angeordnete Grundstrukturschichten (15) insbesondere aus Metall vorgesehen sind, die die strukturierte Oberfläche (31) der Grundstruktur (10) bilden.

5. Presswerkzeug nach einem der Ansprüche 1 bis 4, wobei die erste oder die zweite Keramikschicht (11,12) nur partiell auf der strukturierten Oberfläche (31) der Grundstruktur (10) aufgebracht sind und so eine Reliefschichtstruktur (16) der strukturierten Oberfläche (31) bilden.

6. Presswerkzeug nach einem der Ansprüche 1 bis 4, wobei die erste Keramikschicht (11) und die zweite Keramikschicht (12) jeweils nur partiell auf der strukturierten Oberfläche (31) der Grundstruktur (10) aufgebracht sind.

7. Presswerkzeug nach einem der Ansprüche 1 bis 6, wobei die zweite Keramikschicht (12) zumindest teilweise auf der ersten Keramikschicht (11) angeordnet sind.

8. Presswerkzeug nach einem der Ansprüche 1 bis 7, wobei die erste Keramikschicht (11) oder die zweite Keramikschicht (12) zumindest in einem Laserbearbeitungsbereich (17) mittels eines Lasers bearbeitet ist.

9. Presswerkzeug nach Anspruch 7, wobei in der zweiten Keramikschicht (12) eine Aussparung (5) vorgesehen ist, die in Richtung der Grundstruktur (10) betrachtet, bis zur ersten Keramikschicht (11) reicht.

10. Presswerkzeug nach Anspruch 9, wobei die Aussparung (5) eine durch nachfolgende Bearbeitung der aufgebrachten zweiten Keramikschicht (12) erzeugter Ausschnitt (6) ist.

11. Presswerkzeug nach Anspruch 10, wobei die nachfolgende Bearbeitung eine Laserbearbeitung ist.

12. Presswerkzeug nach einem der Ansprüche 1 bis 11, wobei zumindest eine der an der Pressseite (7) der Grundstruktur (10) angeordneten Metallschichten (15) eine Nickelschicht oder nickelhaltige Metallschicht ist.

13. Presswerkzeug nach einem der Ansprüche 1 bis 12, wobei die strukturierte Oberfläche (31) der Grundstruktur (10) zumindest teilweise in 3-dimensionaler Reliefschichtstruktur (16) mit einem additiven Fertigungsverfahren hergestellt ist.

14. Presswerkzeug nach einem der Ansprüche 1 bis 12, wobei die strukturierte Oberfläche (31) der Grundstruktur (10) zumindest teilweise in 3-dimensionaler Form mit einem elektrochemischen, mechanischen oder Laser-Bearbeitungsverfahren hergestellt ist.

15. Presswerkzeug nach einem der Ansprüche 1 bis 14, wobei die zweite Keramikschicht (12) vollflächig die strukturierte Oberfläche (31) der Grundstruktur (10) bedeckt und eine zweite Dicke (19) aufweist, wobei die erste Keramikschicht (11) eine erste Dicke (18) aufweist, wobei die erste Dicke (18) und die zweite Dicke (19) eine unterschiedliche Schichtdicke aufweisen, um die unterschiedlichen Glanzgrade der ersten und der zweiten Keramikschicht (11, 12) zu erhalten, wobei insbesondere die beiden Keramikschichten (11, 12) aus demselben Keramikmaterial bestehen.

16. Presswerkzeug nach einem der Ansprüche 1 bis 14, wobei sich das Keramikmaterial der beiden Keramikschichten (11, 12) unterscheidet, um die unterschiedlichen Glanzgrade der ersten Keramikschicht (11) und der zweiten Keramikschicht ( 12) zu erhalten, wobei insbesondere die Dicke (19) der zweiten Keramikschicht (12) gleich der Dicke (18) der ersten Keramikschicht (11) ist.

17. Presswerkzeug nach einem der Ansprüche 1 bis 16, wobei das Keramikmaterial der Keramikschichten (11, 12) Hafniumdiborid, Molybdändiborid, Tantaldiborid, Titandiborid, Wolframdiborid, Vanadiumdiborid, Zirkondiborid oder Mischungen dieser Keramikmaterialien ist.

18. Verfahren zum Herstellen eines Presswerkzeugs nach einem der Ansprüche 1 bis 17, aufweisend folgende Verfahrensschritte:
- Bereitstellen einer Tragstruktur (14) für eine Grundstruktur (10),
- Aufbringen von zumindest zwei Grundstrukturschichten (15) auf die Tragstruktur (14) zum Aufbau der Grundstruktur (10)
- Herstellen einer strukturierten Oberfläche (31) auf der Tragstruktur (14)
- Auftragen einer ersten Keramikschicht (11) auf die Oberfläche (31) der Grundstruktur (10), und
- Auftragen einer zweiten Keramikschicht (12) auf die auf der strukturierten Oberfläche (10) und/oder auf die aufgetragene erste Keramikschicht (11).

19. Verfahren nach Anspruch 18, aufweisend
- Auftragen einer partiellen Maske (32) auf die strukturierte Oberfläche (31) der Grundstruktur (10),
- Auftragen einer ersten Keramikschicht (11) auf der mit der Maske versehenen strukturierten Oberfläche (31),
- Entfernen der Maske (32), sodass auf der strukturierten Oberfläche (31) die erste Keramikschicht (11) nur partiell angeordnet ist, und
- vollflächiges Auftragen der zweiten Keramikschicht (12) auf die partiell aufgetragene erste Keramikschicht (11) und die strukturierte Oberfläche (31) der Grundstruktur (10).

20. Verfahren nach Anspruch 18, aufweisend
- vollflächiges Auftragen der ersten Keramikschicht (11) auf die strukturierte Oberfläche (31) der Grundstruktur (10).
- Auftragen einer partiellen Maske (32) auf die ersten Keramikschicht (11),
- Auftragen der zweiten Keramikschicht auf der mit der Maske versehenen ersten Keramikschicht (11)

21. Verfahren nach Anspruch 20, aufweisend Entfernen der Maske (32), sodass auf der strukturierten Oberfläche (31) die erste Keramikschicht (11) nur partiell angeordnet ist.

22. Verfahren nach einem der Ansprüche 19 bis 21, wobei als Maske (32) eine Metallschicht (34), eine Chromschicht, eine Nickelschicht oder nickelhaltige Metallschicht aufgetragen wird.

23. Verfahren nach Anspruch 22, wobei als Maske (32) als funktionale Schicht (35) am Presswerkzeug verbleibt.

24. Verfahren nach einem der Ansprüche 18 bis 24, aufweisend Nachbehandeln der entsprechenden aufgetragenen Keramikschicht (11,12) oder Maske (32), um einen vorgegeben Glanzgrad der entsprechenden Keramikschicht (11,12) oder Maske (32) zu erhalten.

25. Verfahren nach einem der Ansprüche 18 bis 24, aufweisend Auftragen der Keramikschichten (11, 12) mittels eines Flächenmagnetronsputter-Beschichtungssystems (33), wobei das partielle Herstellen der Keramikschicht (11,12) durch geeignetes Ansteuern des Flächenmagnetronsputter-Beschichtungssystems (33).

26. Verfahren nach Anspruch 25, aufweisend
- Transport des Pressbleches (1) auf einem Transportsystem (21)
- Öffnen einer ersten Schleuse (22) zum Bearbeitungsraum (24)
- Transport des Pressbleches (1) in den Bearbeitungsraum (24) des Flächenmagnetronsputter-Beschichtungssystems (33)
- Schließen der ersten Schleuse (22)
- Anlegen eines Vakuums im Bearbeitungsraum (24) mittels einer Vakuumpumpe (29)
- Auftragen einer oder mehrerer Keramikschichten (11, 12) mittels eines Magnetrons (36)
- Öffnen der ersten Schleuse (22) zum Bearbeitungsraum (24)
- Transport des Pressbleches (1) durch die erste Schleuse (22) aus dem Bearbeitungsraum (24) des Flächenmagnetronsputter-Beschichtungssystems (33) heraus.

27. Verfahren nach Anspruch 26 aufweisend die zusätzlichen Schritte
- Transport des Pressbleches (1) durch eine Vakuumvorkammer (25) mit einer Vorkammerschleuse (26) welche Vakuumvorkammer dem Bearbeitungsraum (24) in Transportrichtung gesehen vorgelagert ist, wobei die Vakuumvorkammer (25) mittels einer Vakuumpumpe (30) auf ein Druckniveau gebracht wird welches zwischen dem Atmosphärendruck und einem Bearbeitungsdruck während dem Auftragen einer Keramikschicht (11, 12) im Bearbeitungsraum (25) liegt, wobei dieser Bearbeitungsdruck insbesondere unter 10^-5 mbar, bevorzugt bei 10^-8 mbar liegt.

28. Verfahren nach Anspruch 26 aufweisend die zusätzlichen Schritte
- Transport des Pressbleches (1) durch eine Vakuumvorkammer (25) mit einer Vorkammerschleuse (26) welche Vakuumvorkammer dem Bearbeitungsraum (24) in Transportrichtung gesehen vorgelagert ist, wobei die Vakuumvorkammer (25) mittels einer Vakuumpumpe (30) auf ein Druckniveau gebracht wird, welches zwischen dem Atmosphärendruck und einem Bearbeitungsdruck, während dem Auftragen einer Keramikschicht (11, 12) im Bearbeitungsraum (25) liegt, wobei dieser Bearbeitungsdruck insbesondere unter 10^-5 mbar, bevorzugt bei 10^-8 mbar liegt.
- Transport des Pressbleches (1) durch eine Vakuumnachkammer (27) mit einer Nachkammerschleuse (28), welche Vakuumnachkammer dem Bearbeitungsraum (24) in Transportrichtung gesehen nachgelagert ist, wobei die Vakuumnachkammer (27) mittels einer Vakuumpumpe (30) auf ein Druckniveau gebracht wird, welches zwischen dem Atmosphärendruck und dem Bearbeitungsdruck liegt.

29. Verwendung eines erfindungsgemäßen Presswerkzeuges nach einem der Ansprüche 1 bis 17 zur Herstellung von Werkstoffplatten

## Claims

1. A pressing tool for producing a workpiece, comprising
a pressing surface (2),
a base structure (10), which comprises a surface (31), and
at least two ceramic layers (11, 12) which are arranged on the surface (31) and form the pressing surface (2), **characterized in that** a first ceramic layer (11) has a first degree of gloss and a second ceramic layer (12) has a second degree of gloss, which differs from the first degree of gloss of the first ceramic layer (11).

2. The pressing tool according to claim 1, wherein the pressing tool is a press plate (1) for producing a material board (8).

3. The pressing tool according to claim 1 or 2, wherein the base structure (10) of the pressing tool comprises a support structure (14) made of metal, in particular stainless steel.

4. The pressing tool according to one of claims 1 to 3, wherein the pressing surface (2) has a structure of protrusions (4) and recesses (3), and the base structure (10) has a structured surface (31) provided on the support structure (14), wherein at least two base structure layers (15), in particular made of metal, are provided on the support structure (14), which are arranged at least partially one above the other and form the structured surface (31) of the base structure (10).

5. The pressing tool according to one of claims 1 to 4, wherein the first or the second ceramic layer (11, 12) are applied only partially to the structured surface (31) of the base structure (10) and thus form a relief layer structure (16) of the structured surface (31).

6. The pressing tool according to one of claims 1 to 4, wherein the first ceramic layer (11) and the second ceramic layer (12) are each applied only partially on the structured surface (31) of the base structure (10).

7. The pressing tool according to one of claims 1 to 6, wherein the second ceramic layer (12) is arranged at least partially on the first ceramic layer (11).

8. The pressing tool according to one of claims 1 to 7, wherein the first ceramic layer (11) or the second ceramic layer (12) is processed by means of a laser at least in a laser processing area (17).

9. The pressing tool according to claim 7, wherein a clearance (5) is provided in the second ceramic layer (12), which, viewed in the direction of the base structure (10), extends to the first ceramic layer (11).

10. The pressing tool according to claim 9, wherein the clearance (5) is a cutout (6) produced by subsequent processing of the applied second ceramic layer (12).

11. The pressing tool according to claim 10, wherein the subsequent processing is a laser processing.

12. The pressing tool according to one of claims 1 to 11, wherein at least one of the metal layers (15) arranged on the pressing side (7) of the base structure (10), is a nickel layer or nickel-containing metal layer.

13. The pressing tool according to one of claims 1 to 12, wherein the structured surface (31) of the base structure (10) is at least partially produced in a 3-dimensional relief layer structure (16) using an additive manufacturing process.

14. The pressing tool according to one of claims 1 to 12, wherein the structured surface (31) of the base structure (10) is produced at least partially in a 3-dimensional form using an electrochemical, mechanical or laser processing process.

15. The pressing tool according to one of claims 1 to 14, wherein the second ceramic layer (12) covers the structured surface (31) of the base structure (10) over the entire surface and has a second thickness (19), wherein the first ceramic layer (11) has a first thickness (18), wherein the first thickness (18) and the second thickness (19) have different layer thicknesses in order to obtain the different degrees of gloss of the first and the second ceramic layers (11, 12), wherein in particular the two ceramic layers (11, 12) consist of the same ceramic material.

16. The pressing tool according to one of claims 1 to 14, wherein the ceramic material of the two ceramic layers (11, 12) differs to obtain different degrees of gloss of the first ceramic layer (11) and the second ceramic layer (12), wherein in particular the thickness (19) of the second ceramic layer (12) is equal to the thickness (18) of the first ceramic layer (11).

17. The pressing tool according to one of claims 1 to 16, wherein the ceramic material of the ceramic layers (11, 12) is hafnium diboride, molybdenum diboride, tantalum diboride, titanium diboride, tungsten diboride, vanadium diboride, zirconium diboride or mixtures of these ceramic materials.

18. A method for producing a pressing tool according to one of claims 1 to 17, comprising the following method steps:
- providing a support structure (14) for a base structure (10),
- applying at least two base structure layers (15) onto the support structure (14) to build the base structure (10)
- producing a structured surface (31) on the support structure (14)
- applying a first ceramic layer (11) onto the surface (31) of the base structure (10), and
- applying a second ceramic layer (12) onto the structured surface (10) and/or onto the applied first ceramic layer (11).

19. The method according to claim 18, comprising
- applying a partial mask (32) onto the structured surface (31) of the base structure (10),
- applying a first ceramic layer (11) onto the structured surface (31) provided with the mask,
- removing the mask (32) so that the first ceramic layer (11) is only partially arranged on the structured surface (31), and
- full-surface application of the second ceramic layer (12) onto the partially applied first ceramic layer (11) and the structured surface (31) of the base structure (10).

20. The method according to claim 18, comprising
- full-surface application of the first ceramic layer (11) onto the structured surface (31) of the base structure (10),
- applying a partial mask (32) onto the first ceramic layer (11),
- applying the second ceramic layer onto the first ceramic layer (11) provided with the mask.

21. The method according to claim 20, comprising removal of the mask (32) so that the first ceramic layer (11) is only partially arranged on the structured surface (31).

22. The method according to one of claims 19 to 21, wherein a metal layer (34), a chromium layer, a nickel layer or nickel-containing metal layer is applied as the mask (32).

23. The method according to claim 22, wherein the mask (32) remains on the pressing tool as a functional layer (35).

24. The method according to one of claims 18 to 24, comprising subsequent treatment of the corresponding applied ceramic layer (11, 12) or mask (32) in order to obtain a predetermined degree of gloss of the corresponding ceramic layer (11, 12) or mask (32).

25. The method according to one of claims 18 to 24, comprising application of the ceramic layers (11, 12) by means of a surface magnetron sputter coating system (33), wherein the partial production of the ceramic layer (11, 12) is performed by suitably controlling the surface magnetron sputter coating system (33).

26. The method according to claim 25, comprising
- transport of the press plate (1) on a transport system (21)
- opening of a first lock (22) to the processing chamber (24)
- transport of the press plate (1) into the processing chamber (24) of the surface magnetron sputter coating system (33)
- closing of the first lock (22)
- application of a vacuum in the processing chamber (24) by means of a vacuum pump (29)
- application of one or more ceramic layers (11, 12) by means of a magnetron (36)
- opening of the first lock (22) to the processing chamber (24)
- transport of the press plate (1) through the first lock (22) out of the processing chamber (24) of the surface magnetron sputter coating system (33).

27. The method according to claim 26 comprising the additional steps
- transport of the press plate (1) through a vacuum prechamber (25) with a prechamber lock (26), which vacuum prechamber is upstream of the processing chamber (24) as seen in the transport direction, wherein the vacuum prechamber (25) is brought by means of a vacuum pump (30) to a pressure level which is between atmospheric pressure and a processing pressure during the application of a ceramic layer (11, 12) in the processing chamber (25), wherein this processing pressure is in particular below 10^-5 mbar, preferably at 10^-8 mbar.

28. The method according to claim 26 comprising the additional steps
- transport of the press plate (1) through a vacuum prechamber (25) with a prechamber lock (26), which vacuum prechamber is upstream of the processing chamber (24) as seen in the transport direction, wherein the vacuum prechamber (25) is brought by means of a vacuum pump (30) to a pressure level which is between atmospheric pressure and a processing pressure, during the application of a ceramic layer (11, 12) in the processing chamber (25), wherein this processing pressure is in particular below 10^-5 mbar, preferably at 10^-8 mbar.
- transport of the press plate (1) through a vacuum postchamber (27) with a postchamber lock (28), which vacuum postchamber is located downstream of the processing chamber (24) as seen in the transport direction, wherein the vacuum postchamber (27) is brought by means of a vacuum pump (30) to a pressure level which is between the atmospheric pressure and the processing pressure.

29. A use of a pressing tool according to the invention according to one of claims 1 to 17 for producing material boards.

## Revendications

1. Outil de presse pour la fabrication d'une pièce, comprenant
une surface de pression (2),
une structure de base (10), qui présente une surface (31) et
au moins deux couches de céramique (11, 12) disposées sur la surface (31), qui forment la surface de pression (2),
**caractérisé en ce que**
une première couche de céramique (11) présente un premier degré de brillance et une deuxième couche de céramique (12) présente un deuxième degré de brillance différent du premier degré de brillance de la première couche de céramique (11).

2. Outil de presse selon la revendication 1, dans lequel l'outil de presse est une plaque de presse (1) pour la fabrication d'une plaque de matériau (8).

3. Outil de presse selon la revendication 1 ou 2, dans lequel la structure de base (10) de l'outil de presse comprend une structure porteuse (14) en métal, plus particulièrement en acier inoxydable.

4. Outil de presse selon l'une des revendications 1 à 3, dans lequel la surface de pression (2) présente une structure constituée de bossages (4) et de creux (3) et la structure de base (10) présente une surface structurée (31) prévue sur la structure porteuse (14), dans lequel, sur la structure porteuse (14), sont prévues au moins deux couches de structure de base (15), au moins partiellement superposées, plus particulièrement en métal, qui forment la surface structurée (31) de la structure de base (10).

5. Outil de presse selon l'une des revendications 1 à 4, dans lequel la première ou la deuxième couche de céramique (11, 12) est appliquée seulement partiellement sur la surface structurée (31) de la structure de base (10) et forme ainsi une structure de couche en relief (16) de la surface structurée (31).

6. Outil de presse selon l'une des revendications 1 à 4, dans lequel la première couche de céramique (11) et la deuxième couche de céramique (12) sont appliquées respectivement seulement partiellement sur la surface structurée (31) de la structure de base (10).

7. Outil de presse selon l'une des revendications 1 à 6, dans lequel la deuxième couche de céramique (12) est disposée au moins partiellement sur la première couche de céramique (11).

8. Outil de presse selon l'une des revendications 1 à 7, dans lequel la première couche de céramique (11) ou la deuxième couche de céramique (12) est traitée au moyen d'un laser au moins dans une zone de traitement au laser (17).

9. Outil de presse selon la revendication 7, dans lequel, dans la deuxième couche de céramique (12), est prévu un évidement (5) qui, vu dans la direction de la structure de base (10), arrive jusqu'à la première couche de céramique (11).

10. Outil de presse selon la revendication 9, dans lequel l'évidement (5) est une découpe (6) produite par un usinage ultérieur de la deuxième couche de céramique (12) appliquée.

11. Outil de presse selon la revendication 10, dans lequel l'usinage ultérieur est un traitement au laser.

12. Outil de presse selon l'une des revendications 1 à 11, dans lequel au moins une des couches métalliques (15) disposées sur le côté de pression (7) de la structure de base (10) est une couche de nickel ou une couche métallique contenant du nickel.

13. Outil de presse selon l'une des revendications 1 à 12, dans lequel la surface structurée (31) de la structure de base (10) est fabriquée, au moins partiellement avec une structure tridimensionnelle de couches en relief (16), à l'aide d'un procédé de fabrication additif.

14. Outil de presse selon l'une des revendications 1 à 12, dans lequel la surface structurée (31) de la structure de base (10) est fabriquée, au moins partiellement avec une forme tridimensionnelle, à l'aide d'un procédé électrochimique, mécanique ou un procédé de traitement au laser.

15. Outil de presse selon l'une des revendications 1 à 14, dans lequel la deuxième couche de céramique (12) recouvre entièrement la surface structurée (31) de la structure de base (10) et présente une deuxième épaisseur (19), dans lequel la première couche de céramique (11) présente une première épaisseur (18), dans lequel la première épaisseur (18) et la deuxième épaisseur (19) sont des épaisseurs de couches différentes, afin d'obtenir les différents degrés de brillance des première et deuxième couches de céramique (11, 12), dans lequel, plus particulièrement, les deux couches de céramique (11, 12) sont constituées du même matériau de type céramique.

16. Outil de presse selon l'une des revendications 1 à 14, dans lequel les matériaux de type céramique des deux couches de céramique (11, 12) sont différents, afin d'obtenir les différents degrés de brillance de la première couche de céramique (11) et de la deuxième couche de céramique (12), dans lequel, plus particulièrement, l'épaisseur (19) de la deuxième couche de céramique (12) est égale à l'épaisseur (18) de la première couche de céramique (11).

17. Outil de presse selon l'une des revendications 1 à 16, dans lequel le matériau de type céramique des couches de céramique (11, 12) est du diborure de hafnium, du diborure de molybdène, du diborure de tantale, du diborure de titane, du diborure de tungstène, du diborure de vanadium, du diborure de zirconium ou des mélanges de ces matériaux de type céramique.

18. Procédé de fabrication d'un outil de presse selon l'une des revendications 1 à 17, comprenant les étapes suivantes
- mise à disposition d'une structure porteuse (14) pour une structure de base (10),
- application d'au moins deux couches de structure de base (15) sur la structure de base (14) pour la réalisation de la structure de base (10)
- réalisation d'une surface structurée (31) sur la structure porteuse (14)
- application d'une première couche de céramique (11) sur la surface (31) de la structure de base (10) et
- application d'une deuxième couche de céramique (12) sur la surface structurée (10) et/ou sur la première couche de céramique (11) appliquée.

19. Procédé selon la revendication 18, comprenant
- l'application d'un masque partiel (32) sur la surface structurée (31) de la structure de base (10),
- l'application d'une première couche de céramique (11) sur la surface structurée (31) munie du masque,
- le retrait du masque (32), de sorte que, sur la surface structurée (31), la première couche de céramique (11) est disposée seulement partiellement et
- l'application sur toute la surface de la deuxième couche de céramique (12) sur la première couche de céramique (11) appliquée partiellement et la surface structurée (31) de la structure de base (10).

20. Procédé selon la revendication 18, comprenant
- l'application sur toute la surface de la première couche de céramique (11) sur la surface structurée (31) de la structure de base (10),
- l'application d'un masque partiel (32) sur la première couche de céramique (11),
- l'application de la deuxième couche de céramique (12) sur la première couche de céramique (11) munie du masque.

21. Procédé selon la revendication 20, comprenant le retrait du masque (32), de sorte que, sur la surface structurée (31), la première couche de céramique (11) est disposée seulement partiellement.

22. Procédé selon l'une des revendications 19 à 21, dans lequel, en tant que masque (32), on applique une couche métallique (34), une couche de chrome, une couche de nickel ou une couche métallique contenant du nickel.

23. Procédé selon la revendication 22, dans lequel le masque (32) reste en tant que couche fonctionnelle (35) sur l'outil de presse.

24. Procédé selon l'une des revendications 18 à 24, comprenant un traitement ultérieur de la couche de céramique (11, 12) ou du masque (32) appliqué correspondant, afin d'obtenir un degré de brillance prédéterminé de la couche de céramique (11, 12) ou du masque (32) correspondant.

25. Procédé selon l'une des revendications 18 à 24, comprenant l'application des couches de céramique (11, 12) au moyen d'un système de revêtement par pulvérisation par magnétron de surface (33), dans lequel la réalisation partielle de la couche de céramique (11, 12) est effectuée à l'aide d'un contrôle approprié du système de revêtement par pulvérisation par magnétron de surface (33).

26. Procédé selon la revendication 25, comprenant
- le transport de la plaque de presse (1) sur un système de transport (21)
- l'ouverture d'un premier sas (22) vers la chambre de traitement (24)
- le transport de la plaque de presse (1) vers la chambre de traitement (24) du système de revêtement par pulvérisation par magnétron de surface (33)
- la fermeture du premier sas (22)
- l'application d'un vide dans la chambre de traitement (24) au moyen d'une pompe à vide (29)
- l'application d'une ou plusieurs couches de céramique (11, 12) au moyen d'un magnétron (36)
- l'ouverture du premier sas (22) vers la chambre de traitement (24)
- le transport de la plaque de presse (1) à travers le premier sas (22) hors de la chambre de traitement (24) du système de revêtement par pulvérisation par magnétron de surface (33).

27. Procédé selon la revendication 26, comprenant les étapes supplémentaires suivantes
- transport de la plaque de presse (1) à travers une pré-chambre à vide (25) avec un sas de pré-chambre (26), cette pré-chambre à vide étant disposée, vue dans la direction de transport, en amont de la chambre de traitement (24), dans lequel la pré-chambre à vide (25) est amenée, au moyen d'une pompe à vide (30), à un niveau de pression qui se trouve entre la pression atmosphérique et une pression de traitement pendant l'application d'une couche de céramique (11, 12) dans la chambre de traitement (25), dans lequel cette pression de traitement est plus particulièrement inférieure à 10⁻⁵ mbar, de préférence est égale à 10⁻⁸ mbar.

28. Procédé selon la revendication 26, comprenant les étapes supplémentaires suivantes
- transport de la plaque de presse (1) à travers une pré-chambre à vide (25) avec un sas de pré-chambre (26), cette pré-chambre à vide étant disposée, vue dans la direction de transport, en amont de la chambre de traitement (24), dans lequel la pré-chambre à vide (25) est amenée, au moyen d'une pompe à vide (30), à un niveau de pression qui se trouve entre la pression atmosphérique et une pression de traitement pendant l'application d'une couche de céramique (11, 12) dans la chambre de traitement (25), dans lequel cette pression de traitement est plus particulièrement inférieure à 10⁻⁵ mbar, de préférence est égale à 10⁻⁸ mbar,
- transport de la plaque de presse (1) à travers une post-chambre à vide (27) avec un sas de post-chambre (28), cette post-chambre à vide étant disposée, vue dans la direction de transport, en aval de la chambre de traitement (24), dans lequel la post-chambre à vide (27) est amenée, au moyen d'une pompe à vide (30), à un niveau de pression qui se trouve entre la pression atmosphérique et la pression de traitement.

29. Utilisation d'un outil de presse selon l'invention selon l'une des revendications 1 à 17 pour la fabrication de plaques de matériau.
